# EUROPÄISCHE PATENTSCHRIFT

(11) **EP 0 440 683 B1**
(45) Veröffentlichungstag und Bekanntmachung des Hinweises auf die Patenterteilung: **14.09.1994**
(21) Anmeldenummer: 89911251.0
(22) Anmeldetag: 04.10.1989
(51) Int. Cl.: G06F 15/80, G02B 6/42, G06E 1/00

(54) **DIGITALRECHNER MIT MULTIPROZESSORANORDNUNG**
DIGITAL COMPUTER WITH MULTIPROCESSOR ARRANGEMENT
CALCULATEUR NUMERIQUE A CONFIGURATION DE MULTIPROCESSEUR

(30) Priorität: 19.10.1988 DE 3835601
(43) Veröffentlichungstag der Anmeldung: 14.08.1991
(73) Patentinhaber: WENDT, Hans-Joachim, D-21614 Buxtehude (DE)
(72) Erfinder: WENDT, Hans-Joachim, D-21614 Buxtehude (DE)
(74) Vertreter: Schmidt-Bogatzky, Jürgen, Dr. Ing.
(86) Internationale Anmeldenummer: EP8901162
(87) Internationale Veröffentlichungsnummer: WO9004835

(56) Entgegenhaltungen:
- EP-A- 0 101 872
- EP-A- 0 150 929
- WO-A-84/00822
- WO-A-85/03179
- GB-A- 2 152 749
- US-A- 4 481 423
- PROCEEDINGS OF THE IEEE, VOL. 72, NO.7, JULY 1984, IEEE J.W. GOODMAN ET AL.: "OPTICAL INTER-CONNECTIONS FOR VLSI SYSTEMS", PAGES 850-866, SEE FIGURES11-15;
- IBM TECHNICAL DISCLOSURE BULLETIN, VOL. 26, NO. 4, SEPTEMBER 1983, (NEW YORK, US), L. BALLIET ET AL.: "OPTICAL TRANSMISSION SYSTEM FOR INTERCONNECTING ELECTRONIC UNITS", PAGES 1793-1796
- ELECTRONICS LETTERS, VOL. 17, NO. 22, 29 OCTOBER 1981, (LONDON, GB), K. OGAWA ET AL.: "WAVELENGTH DIVISION MULTIPLEXING EXPERIMENT EMPLOYING DUALWAVELENGTH LEDS AND PHOTODETECTORS", PAGES 857-859,
- COMPUTER, VOL. 20, NO. 4, APRIL 1987, (NEW YORK, N.Y. US), D. MILUTINOVIC ET AL.: "THE HONEYCOMB ARCHITECTURE", PAGES 81-83
- APPLIED OPTICS, VOL. 25, NO. 10, 15 MAY 1986, OPTICAL SOCIETY OF AMERICA, (NEW YORK, US), T. YATAGAI: "CELLULAR LOGIC ARCHITECTURES FOR OPTICAL COMPUTERS", PAGES 1571-1577
- THE BELL SYSTEM TECHNICAL JOURNAL, VOL. 58, NO. 7, SEPTEMBER 1979, AMERICAN TELEPHONE AND TELEGRAPH COMPANY, (US), R.C. MILLER ET AL.: "OPTICALLY POWERED SPEECH COMMUNICATION OVER A FIBER LIGHTGUIDE", PAGES 1753-1741

## Beschreibung

Die Erfindung bezieht sich auf einen Rechner nach dem Oberbegriff des Anspruchs 1.

Nach heutiger Kenntnis können rechnerrelevante Signale sowohl elektrisch als auch optisch übertragen werden. Dabei besteht grundsätzlich die Möglichkeit, diese beiden Übertragungsarten außerhalb und innerhalb der Computerchips anzuwenden. Die Entwicklung optischer Chips wird zur Zeit betrieben, hat aber bei weitem noch nicht den hohen Stand, insbesondere in der Miniaturisierung erreicht, wie er bei elektronischen Chips bereits vorliegt. Es gibt also sowohl optische als auch elektronische Bauelemente für Rechner, um Schaltungen nach der einen oder der anderen Übetragungsart aufzubauen. Daneben gibt es sog. optronische Bauelemente zur Realisierung von Übergängen zwischen Schaltungsbereichen mit unterschiedlicher Übertragungsart.

Bei gattungsgemäßen Digitalrechnern werden gleichzeitig mehrere Prozessor-Einheiten betrieben, um die Rechnergeschwindigkeit zu erhöhen. Sofern es sich dabei um Rechner mit neuronalen Netzwerken handelt, kann durch den gleichzeitigen Betrieb vieler Prozessoren eine mehr oder weniger ausgeprägte Lernfähigkeit der Rechner erreicht werden. Die einzelnen Funktions-Einheiten, Prozessoren und Speicher, weisen bei elektronischen Chips eine hohe Packungsdichte auf. Hierdurch wird der Platzbedarf eines derartigen Rechners verringert und die Länge der internen Übertragungswege verkürzt. Die hohe Packungsdichte wird dadurch erreicht, daß die einzelnen auf einem Chip angeordneten elektronischen Schaltelemente mit Hilfe der sog. Elektronenstrahl-Lithographie immer stärker miniaturisiert werden. Mit auf derartigen Chips basierenden Rechnersystemen sind bereits beachtliche Funktionsdichten erzielbar. Dennoch ist abzusehen, daß der Entwicklung rein elektronischer Superrechner Grenzen gesetzt sind. Mit "Superrechner" sind hier sog. lernfähige Rechner gemeint, die nur in Multiprozessor-Anordnungen in Form neuronaler Netzerke denkbar sind, wobei die Anzahl der zusammenwirkenden Prozessoren, je nach Anwendung, beispielsweise fünfstellig oder auch um Größenordnungen höher sein kann. Rechnerstrukturen mit derartigen Anzahlen von Einzelprozessoren sind unter Beibehaltung akzeptabler Geräteabmessungen mit Prozessoren üblicher Bauart nicht mehr zu realisieren. In der US-Z Aerospace America/June 1988, Seite 40, Spalte 2, Zeilen 28 bis 41, ist ein Rechner, basierend auf VLSIC-Technik (Very Large Scale Integrated Chip) beschrieben, der 250.000 Prozesse und 5 Millionen Querverbindungen ausführen kann. Hier wird dann weiter ausgeführt, daß einige Millionen von Querverbindungen je nach Anwendung bei weitem zu wenig sein können. So erfordert die Muster-Erkennung mittels eines optischen Aufnahmeorgans mit einer Million optoelektrisch aktiver Einzelelemente, beispielsweise eine in die Milliarden gehende Anzahl von Querverbindungen zwischen den einzelnen Einheiten des Rechners. Um die Entwicklung in dieser Richtung voran zu treiben, müßten neue Wege der Chip-Kontaktierung gefunden werden, da die Zusammenschaltung von derart vielen Prozessoren durch die derzeitige Kontaktierungstechnik sehr stark eingeschränkt wird. Bei dieser Technik werden die einzelnen Chips durch üblicherweise an ihren Gehäuserändern angeordnete Lötanschlüsse mit der übrigen Rechnerschaltung verbunden.

Bezüglich der Erstellung von Superrechnern der vorgenannten Art bietet die elektrische Übertragungsart folgenden Vorteil:
- Die Möglichkeiten der Miniaturisierung bei der Chipherstellung können voll genutzt werden. Hierbei sind Bauelement-Abmessungen, beispielsweise Leiterbahnbreiten von 0,01 µm, realisierbar.

Dem stehen jedoch folgend Nachteile gegenüber:
- Die notwendige hohe Anzahl von Querverbindungen außerhalb der Chips erschwert die Entwicklung von Superrechnern außerordentlich.
- Die elektrischen Querverbindungen sind, wie alle derartigen Leitungen, sehr empfindlich gegenüber elektromagnetischen Störfeldern.
- Die auf den elektrischen Übertragunswegen immer vorhandenen Induktivitäten und Kapazitäten bewirken eine erhebliche Einschränkung der Übertragungsgeschwindigkeit sowie der Übertragungsbandbreite auf diesen Wegen.

Betrachtet man die Brauchbarkeit optischer Konzepte zur Realisierung von Superrechnern, so stößt man insbesondere auf folgenden Nachteil:
- Bisher realisierte oder konzipierte optische Chips weisen nicht den hohen Grad der Miniaturisierung auf, wie er bei elektronischen Chips bereits erreicht ist.

Vorteilhaft bei optischen Rechnerkonzepten ist jedoch folgendes:
- Die betreffenden Übertragungswege sind unempfindlich gegen elektromagnetische Störfelder.
- Die optischen Übertragungswege weisen weder störende Induktivitäten noch Kapazitäten auf.

Die Frage optisch oder elektrisch stellt sich nicht nur bezüglich der Chips und deren Verbindungen untereinander sondern auch bezüglich der Peripherie eines Rechners, also bezüglich der Bildschirme, Tastaturen, Sensoren, Laufwerksschaltungen und so weiter. Um diese Geräte weitgehend gegen elektromagnetische Einflüsse unempfindlich zu machen, werden diese üblicherweise entsprechend abgeschirmt, wobei die Datenleitungen bereits durch Lichtwellenleiter realisiert sein können. Zum Scnutz gegen Störungen, die über die Versorgungsleitungen in die Geräte gelangen, sind weitere Entstörmaßnahmen erforderlich. Entsprechende Lösungen sind insbesondere wegen der benötigten Abschirmungen und Filteranordnungen relativ aufwendig.

Demgemäß liegt der Erfindung die Aufgabe zugrunde, einen gattungsgemäßen Rechner und die damit zusammenwirkenden peripheren Geräte derart auszubilden, daß darin die Vorteile der optischen Übertragungsart mit den Vorteilen der elektronischen Signalverarbeitung so vereint werden, daß sich der Rechner und die peripheren Geräte durch eine weitgehende Unstörbarkeit durch elektromagnetische Einflüsse auszeichnen, wobei die für Superrechner typischen Anzahlen von Querverbindungen realisierbar sind.

Diese Aufgabe wird bei einem gattungsgemäßen Rechner durch die kennzeichnenden Merkmale des Patentanspruchs 1 gelöst.

Dabei ist insbesondere von Vorteil, daß sich neue Wege der Chip-Zusammenschaltung ergeben, so daß eine hohe Packungsdichte der Chips und eine große Zahl von Querverbindungen erreicht wird; hieraus resultiert eine hohe Funktionsdichte des Rechner-Netzwerks bei gleichzeitiger Unstörbarkeit Rechners und der peripheren Geräte durch elektromagnetische Einflüsse.

Vorteilhafte Weiterbildungen der Erfindung sind in den Unteransprüchen angegeben.

Bei der Ausgestaltung nach Anspruch 2 geschieht die Stromversorgung des einzelnen Chips durch Lichteinstrahlung. Damit sind bei gleichzeitiger optischer Datenübermittlung elektrische Zuleitungen zum Chip nicht mehr erforderlich.

Durch die Lösung nach Anspruch 3 wird die Möglichkeit eröffnet, ein "Farbmultiplex-Verfahren" anzuwenden.

Bei der Chipform nach Anspruch 4 werden die Chipgrenzen von den Lichtwellenleitern rechtwinklig gekreuzt.

Die Chips verbleiben auf dem Trägermaterial, auf den sie hergestellt wurden und werden hier zu einem Prozessornetzwerk zusammengeschaltet.

Durch die Ausgestaltung nach Anspruch 6 erhält das Prozessor-Netzwerk eine räumliche Dimension.

Die Erfindung ist anhand der Zeichnung dargestellt und in der Beispielbeschreibung näher erläutert. Es zeigen
- Fig. 1: ein Blockschaltbild eines Superrechners,
- Fig. 2: einen Querschnitt durch einen mehrlagigen Chip,
- Fig. 3: eine metallisierte Beschichtung,
- Fig. 4: eine Lichtleiterschicht,
- Fig. 5: eine Photozellenschicht,
- Fig. 6: einen Chip mit Funktions-Einheiten,
- Fig. 7: eine Deckschicht,
- Fig. 8: eine Chip-Gruppierung,
- Fig. 9: eine Energieversorgung für eine Chip-Struktur,
- Fig. 10: einen Einkoppelpunkt,
- Fig. 11: eine Anzeige-Einheit,
- Fig. 12: eine Ansteuerschaltung für die Anzeige-Einheit nach Fig. 11,
- Fig. 13: ein Taster-Element,
- Fig. 14: eine Beschaltung für eine Tastatur mit Taster-Elementen nach Fig. 13,
- Fig. 15: ein Mikrofon mit Beschaltung,
- Fig. 16: ein Sprachausgabeteil,
- Fig. 17: einen Bildsensor,
- Fig. 18: eine Massenspeicher-Anordnung,
- Fig. 19: einen kombinierten Druck/Temperatur-Sensor und
- Fig. 20: eine Signalstruktur.

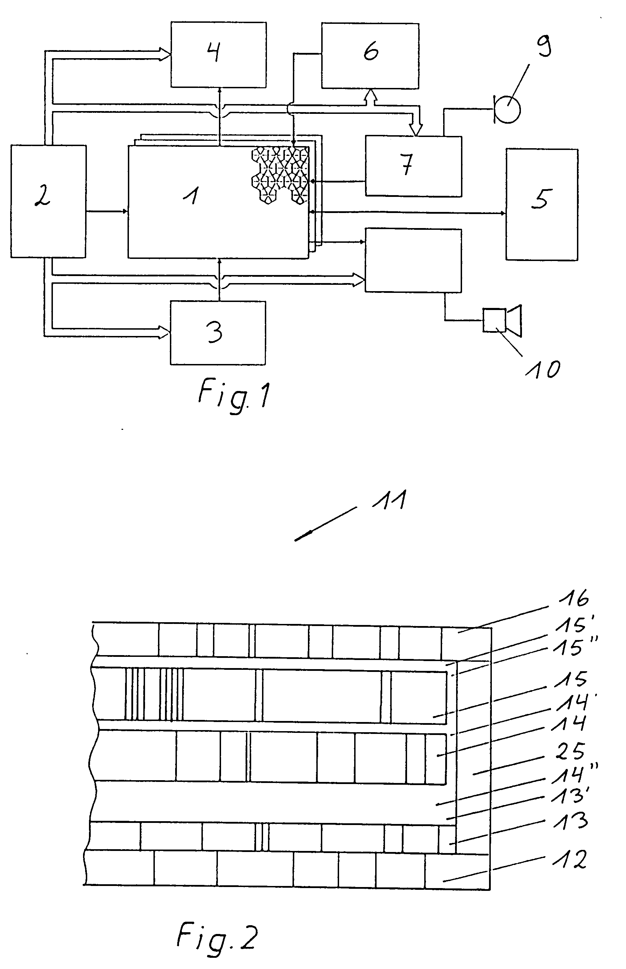

Fig. 1 zeigt ein Blockschaltbild eines erfindungsgemäßen Rechners mit einem neuronalen Prozessor-Netzerk 1, woran folgende Funktions-Einheiten angeschlossen sind. Eine Energieversorgungs-Einheit 2, ein Daten-Eingabefeld 3, eine Anzeige-Einheit 4, ein magnetischer Massenspeicher 5, ein Bildsensor 6, eine Sprachanalyse-Einheit 7 und eine Sprachsynthese-Einheit 8. Weiterhin steht die Energieversogungs-Einheit 2, wie dargestellt, mit jeder der Einheiten 3 bis 8 in Verbindung. Das Prozessor-Netzwerk 1 weist einige Hunderttausend einzelner Prozessor-Chips auf, die miteinander ein hochgradig vermaschtes Netzwerk bilden. Die im Schaltbild gezeigten Leitungen sind als Lichtwellenleiter ausgebildet. Alle Ein- und Ausgänge der einzelnen Funktions-Einheiten weisen an die Lichtwellenleiter angeschlossene optoelektronische Wandler auf. Auch die von der Energieversorgungs-Einheit 2 kommenden Energieleitungen sind als Lichtwellenleiter ausgebildet. Infolge des hochgradig vermaschten neuronalen Netzwerkes 1 ist dieser Rechner in gewissem Umfang lernfähig und kann außer den üblichen logischen Operationen auch solche der Muster-Erkennung ausführen. Dabei ist sowohl eine optische als auch eine akustische Muster-Erkennung, durchführbar. Bei optischer Muster-Erkennung erfolgt die Signal-Eingabe in den Rechner 1 durch den Bildsensor 6 und/oder durch den Massenspeicher 5. Bei akustischer Muster-Erkennung erfolgt die Dateneingabe durch die Sprachanalyse-Einheit 7, die mit einem Mikrofon 9 zusammenwirkt. Die Sprachausgabe erfolgt anhand der Sprachsynthese-Einheit 8, an die ein Lautsprecher 10 angeschlossen ist.

Fig. 2 zeigt schematisch einen Querschnitt durch einen einzelnen Prozessor-Chip 11, wie er in dem obigen Prozessor-Netzwerk 1 verwendet wird. Dieser Chip enthält einen kompletten Prozessor und bildet die Grundlage der Rechnerschaltung. Der Chip besteht im einzelnen aus einer metallischen, als elektromagnetische Abschirmung dienenden, Trägerschicht 12, auf der die weiteren Schichten angeordnet sind. Auf der Schicht 12 ist eine Lichtleiterschicht 13, bestehend aus einem verlustarmen Material, wie Silikat, angeordnet. Oberhalb der Schicht 13 befindet sich eine Fotozellenschicht 14, beispielsweise bestehend aus kristallinem Silizium, worüber eine Schaltungsträger-Schicht 15 angeordnet ist, die beispielsweise aus Silizium oder GaAs (Galliumarsenid) bestehen kann. Innerhalb dieser Schicht 15 befindet sich die mittels hoch auflösender Verfahren, z.B. mittels Elektronen-Strahl-Lithographie, hergestellte Schaltung des Prozessors. Den oberen Abschluß des Chips bildet eine Deckschicht 16. Diese Schicht besteht, wie die Träger-Schicht 12, aus Metall, und enthält definierte Lichtleiter-Bahnen. Zwischen den Schichten 13 und 14, 14 und 15 sowie 15 und 16 ist je eine mit 13′, 14′ bzw. 15′ bezeichnete, aus SiO₂ bestehende Isolierschicht angeordnet. Die genannten Isolierschichten gehen in Rand-Schichten 14˝, 15˝ über, wodurch die Schichten 14 und 15 von. einer metallischen Randschicht 25 elektrisch getrennt sind.

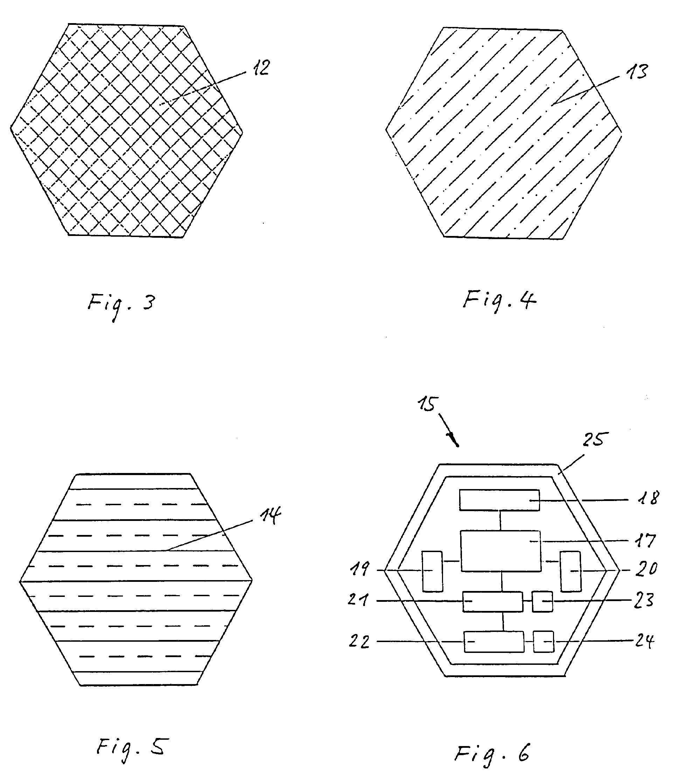

Fig. 3 zeigt in der Draufsicht den auf die Fläche des Chips bezogenen Bereich der metallischen Trägerschicht 12. Dieser Bereich hat die Form eines regelmäßigen Sechsecks, so daß die einzelnen Chips platzsparend auf der Trägerschicht 12 angeordnet werden können. Die zwischen der Schicht 12 und der Schicht 13 befindliche Grenzfläche ist derart ausgebildet, daß das in die Lichtleiter-Schicht 13 eingeleitete Licht hier maximal reflektiert und der Fotozellenschicht zugeführt wird.

Fig. 4 zeigt eine Draufsicht der Lichtleiter-Schicht 13. Auch diese Schicht ist, wie alle anderen Schichten des Chips von sechseckiger Form. Diese Schicht leitet das mit hoher Leistungsdichte eingeleitete multispektrale Licht multimodal in die Fotozellenschicht 14 weiter.

Fig. 5 zeigt eine Draufsicht der Fotozellenschicht 14. Diese Schicht weist eine bestimmte Anzahl von Fotozellen auf, so daß diese bei Belichtung von der Lichtleiter-Schicht 13 her eine elektrische Spannung liefert, die um 20 bis 30% höher ist als die Spannung, die für die Versorgung der in der Schicht 15 angeordneten Schaltung benötigt wird. Damit ergibt sich ein genügend großer Regelbereich für einen sicheren Betrieb des Rechnerchips. Die Fotozellen-Schicht 14 ist durch eine aus SiO₂ bestehende Isolierschicht 14′ von der Schaltungsträger-Schicht 15 getrennt.

Fig. 6 zeigt eine Draufsicht der Schaltungsträger-Schicht 15. Auf dieser Schicht sind die einzelnen Funktions-Einheiten des Chips aufgebaut. Das Bild zeigt im einzelnen folgende Einheiten. Eine Prozessor-Einheit 17, eine Versorgungs-Einheit 18, einen programmierbaren Speicher 19, einen Direktzugriffs-Speicher 20, einen Bus-Coder 21, einen Bus-Decoder 22, einen optischen Sender 23 sowie einen optischen Empfänger 24. Die Prozessor-Einheit 17 kann als 8-, 16- oder 32-Bit-Rechner ausgeführt sein. Die Versorgungs-Einheit 18 steht mit der Fotozellen-Schicht 14 in Verbindung und erhält von hier ihre Eingangsspannung. Hierzu weist die Isolierschicht 14′ eine entsprechende vertikale Durchkontaktierung auf. Die Versorgungs-Einheit 18 stabilisiert die Eingangsspannung auf einen vorbestimmten Wert und versorgt damit über entsprechende elektrische Leiterbahnen alle Funktions-Einheiten des Chips. Die Funktions-Einheiten stellen hoch integrierte Halbleiterschaltkreise dar, die über einen internen elektrischen Rechnerbus miteinander verbunden sind. Die Draufsicht zeigt weiterhin eine geschlossen umlaufende metallische Randschicht 25, die die gesamte auf dem Chip angeordnete Schaltung umgibt. Diese Schicht stellt in Verbindung mit den metallischen Schichten 12 und 16 eine äußerst wirksame Abschirmung gegen magnetische und elektromagnetische Einflüsse dar. Der Datenaustausch mit den anderen in dem neuronalen Netzwerk in großer Zahl zusammengefaßten weiteren Prozessor-Chips und mit den peripheren Einheiten erfolgt über den optischen Sender 23 bzw. über den Empfänger 24. Damit ist der Prozessor nur noch über optische Übertragungswege mit der Außenwelt verbunden, wodurch sich eine minimale Empfindlichkeit gegen elektromagnetische Störfelder ergibt.

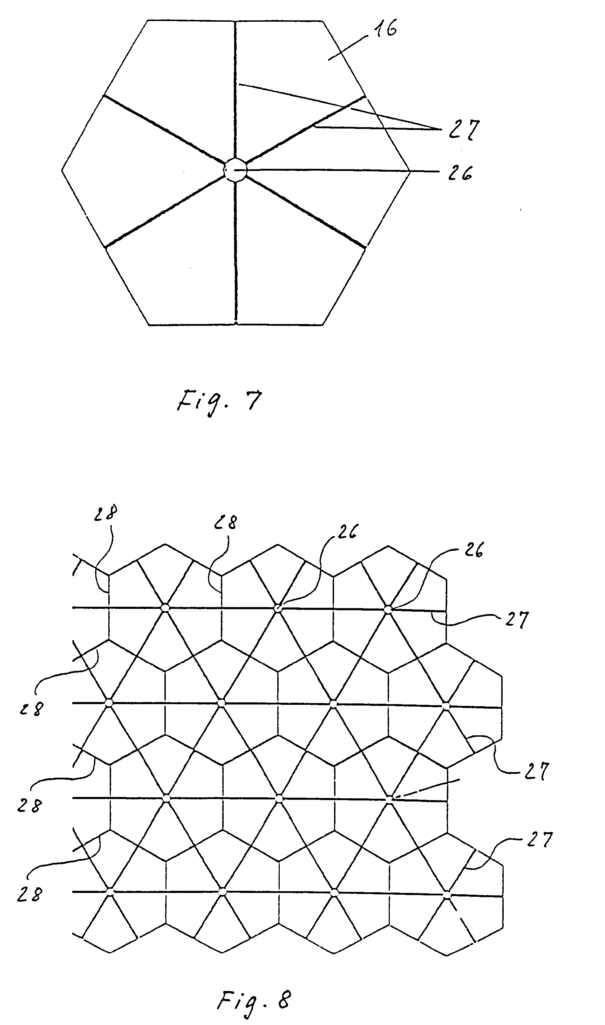

Fig. 7 zeigt eine Draufsicht der Lichtleiter-Schicht 16 nach Fig. 2. Diese ebenfalls sechseckig ausgebildete Schicht weist in ihrer Mitte einen optischen Knoten 26 auf. In diesen Knoten münden sternförmig sechs Lichtwellenleiter 27 ein. Die Lichtwellenleiter 27 bestehen aus einem polymeren Material von vorbestimmter Dämpfung und sind in innerhalb der Schicht 16 angeordnete vertiefte Bahnen eingebracht. Der Knoten 26 wirkt als optisches Koppelglied und bringt die chipseitigen Coder bzw. Decoder-Einheiten 21,20 über den jeweiligen Sender 23 bzw. Empfänger 24 mit den Lichtwellenleitern 27 in optischen Kontakt.

Fig. 8 zeigt einen Ausschnitt eines Prozessor-Netzwerks, bestehend aus mehreren Prozessor-Chips, die infolge der Sechseckform unter optimaler Flächenausnutzung aneinandergefügt sind. Die einzelnen Chips stehen über ein aus den Lichtwellenleitern 27 gebildetes Netzwerk miteinander in Verbindung. Die Leiter 27 sind in die geschlossene Träger-Schicht 16 eingebettet, die alle Prozessor-Chips überdeckt. Die Knoten 26 fungieren sowohl als aktive als auch als passive Sternkoppler des Netzwerks. Infolge der Sechseckform der Chips mit der zentralen Anordnung der Knoten 26 bildet das Netzwerk dreieckige Maschen mit den Knoten als Eckpunkten, wobei jeder Knoten 26 mit sechs Lichtwellenleitern 27 verbunden ist. Dabei ergibt sich als geometrischer Sonderfall, daß alle Chipgrenzen 28 von den Lichtwellenleitern 27 rechtwinklig gekreuzt werden. Durch Integration einer Vielzahl derartiger Chips mit den vorbeschriebenen Schichten 12,13 und 15,16 wird jeweils eine Prozessorebene gebildet, die mit weiteren derartigen Ebenen zu einem Block vereinigt ist. Dabei sind an vorbestimmten Stellen der Ebenen optische Durchkontaktierungen vorgesehen, so daß das Prozessor-Netzwerk eine räumliche Dimension von äußerst hoher Funktionsdichte erhält.

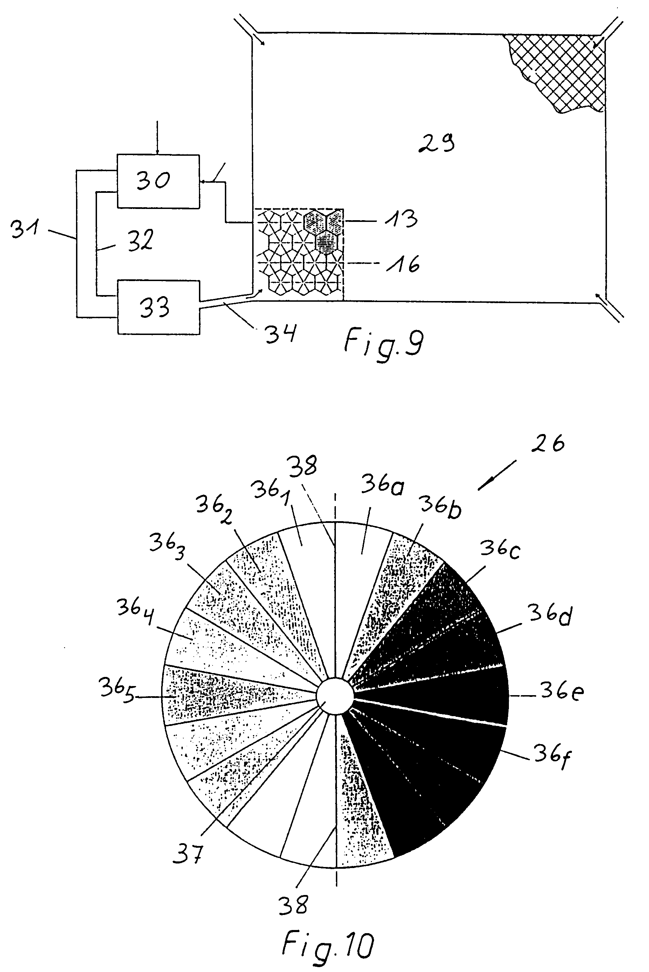

Fig. 9 zeigt die Energieversorgung einer aus den Schichten 12 bis 16 gebildeten Ebene 29 des Prozessor-Netzwerks mit einer geregelten Stromversorgung 30, die über elektrische Leitungen 31,32 mit einer Lichtquelle 33 in Verbindung steht. Links unten innerhalb der rechteckigen Ebene 29 ist die vorbeschriebene Chipstruktur schematisch gezeigt. Zu sehen sind die Deckschicht 16 mit den Lichtwellenleitern 27 sowie ausschnittsweise die schraffiert dargestellte Fotozellenschicht 13. Das von der Lichtquelle 33 erzeugte Licht gelangt über einen geeigneten Lichtwellenleiter 34 in die Lichtleiterschicht 13 der Prozessorebene 29 und wirkt von hier aus auf die Fotozellenschicht 13 ein. In der Fotozellenschicht 13 entsteht daraufhin eine elektrische Spannung, die der Stromversorgung der einzelnen Chips dient. Von dieser Spannung wird ein elektrisches Kontrollsignal abgeleitet und der Energieversorgung 30 als Bezugsgröße über eine Leitung 35 zugeführt.

Fig. 10 zeigt eine Draufsicht eines optischen Knotens 26. Dieser stellt praktisch eine Anordnung von kreissegmentförmigen Fotodioden 36 dar, die gemeinsam eine geschlossene Kreisfläche überdecken. Das Zentrum 37 des Kreises ist aus fertigungstechnischen Gründen ausgespart. Durch eine diametrale Trennlinie 38 sind die Dioden 36 in zwei Gruppen eingeteilt, und zwar in Sende-Dioden 36a, 36b, 36c,... und Empfangs-Dioden, die mit 36₁, 36₂, 36₃,... bezeichnet sind. Die einzelnen Sende-Dioden 36a, 36b, 36c,... arbeiten auf unterschiedlichen Wellenlängen (Farben), wobei jeder Sende-Diode eine Empfangs-Diode zugeordnet ist, die auf der gleichen Wellenlänge arbeitet. Topografisch gesehen besteht die Anordnung aus mehreren Sendedioden und Empfangsdioden von jeweils kreissegmentförmigem Umriß, wobei die einzelnen Farbsegmente eine farbcharakteristische Dotierung aufweisen und getrennt über entsprechende mikroelektronische Leitungen ansteuerbar sind. Die Licht emittierenden Flächen der Diodenanordnung sind durch einen hier nicht gezeigten Kopplungskörper abgedeckt, der die optische Verbindung zwischen den einzelnen Dioden 36 und den Lichtwellenleitern 27 herstellt. Mittels dieser optischen Knoten kann jeder Prozessor 11 Daten mit den anderen Prozessoren des Netzwerks im kombinierten Farbmultiplex- und Zeitmultiplex-Verfahren austauschen.

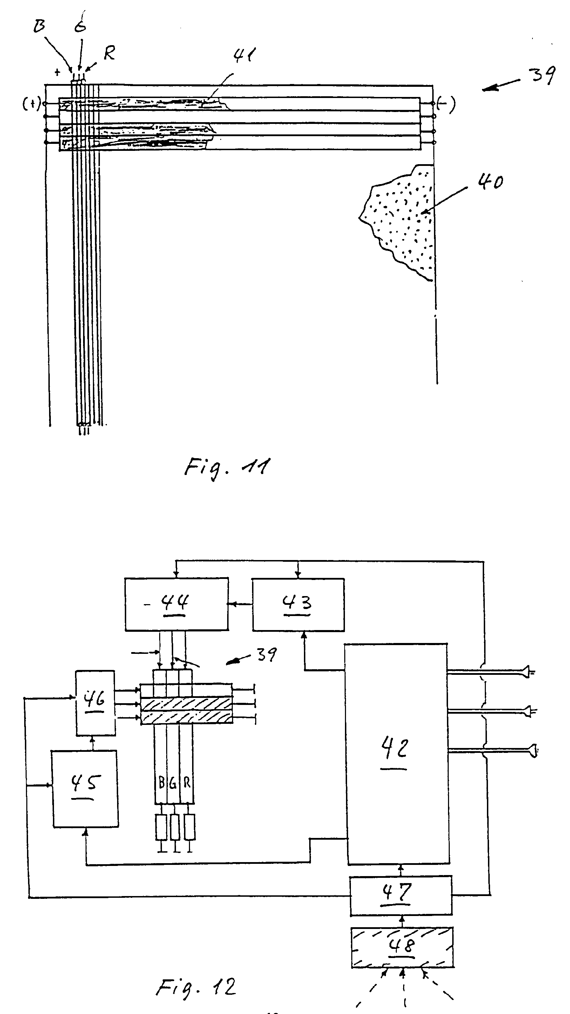

Fig. 11 zeigt eine Ansicht eines Anzeigefeldes (Display) 39, das auf einer Trägerplatte 40 angeordnet ist. Auf dieser Platte 40 ist eine Vielzahl streifenförmiger vertikal verlaufender einzeln ansteuerbarer Leuchtdioden (LED) B,G,R; B,G,R; B,G,R; ... angeordnet, wovon hier nur wenige gezeigt sind. Diese in dichter Folge angeordneten Dioden B,G,R bedecken in einer ersten Schicht die gesamte optisch nutzbare Fläche des Anzeigefeldes 39. Dabei stehen die Bezugszeichen B,G,R für Blau, Rot und Grün. Die Gesamtbreite einer derartigen Dreiheit von Dioden entspricht gerade der Breite eines Bildpunktes. Über dieser ersten Schicht liegt in einer zweiten Schicht eine Vielzahl streifenförmiger horizontal angeordneter Flüssigkristall (LCD)-Elemente 41. Auch diese einzeln ansteuerbaren Elemente bedecken in dichter Folge die gesamte sichtbare Fläche der Anzeige wobei die Breite eines Elementes 41 gerade der Höhe eines Bildpunktes entspricht. Zum Schutz der Anordnung ist eine dritte Schicht aus einem durchsichtigen Material vorgesehen, deren Oberfläche derart ausgebildet ist, daß darauf auftreffendes Außenlicht diffus reflektiert wird. Das Display 39 ist komplett dunkel gesteuert, wenn alle LCD-Elemente 41 an der Versorgungsspannung liegen. Das darzustellende Bild wird wie in einer Kathodestrahlbildröhre punkt- und zeilenweise zusammengesetzt, wobei auch hier jede Zeile aus einer Folge von Punkten besteht. Bei dem gezeigten Display entfällt jedoch eine punktweise komplizierte Punkt-Matrixverdrahtung, wie sie bei direktanzeigenden Halbleiter-Displays erforderlich ist. Durch einen Abschaltimpuls wird die Dunkelsteuerung der jeweiligen LCD-Zeile abgeschaltet, so daß die dahinter liegenden Leuchtdioden sichtbar werden. Dadurch wird ein Ausschnitt von der Höhe einer Bildzeile für die dahinter liegenden LEDs durchlässig. Ein Bildpunkt wird gezeigt, wenn nun gerade eine Dreiheit B,G,R von Dioden angesteuert wird. Dabei ergeben sich Farbe und Helligkeit des Bildpunktes aus den Ansteuerungsverhältnissen. Ein Vorteil dieser Lösung besteht darin, daß der Bilddurchlauf mittels der LCD-Elemente und der wesentlich schnellere Zeilendurchlauf mittels der hierfür besser geeigneten LED-Elemente ausgeführt wird. Den punkt- und zeilenweisen Aufbau eines derartigen Bildes mit Ansteuerung der Farb- und Helligkeitswerte übernimmt eine entsprechende Bildansteuerung.

Fig, 12 zeigt das Display 39 nach Fig. 11 mit den LEDs B,G,R und den LCDs 41 mit seiner äußeren Beschaltung, bestehend aus einem Display-Prozessor 42, einer LED- Spaltensteuerung 43, einem LED-Spaltentreiber 44 sowie einer LCD- Zeilensteuerung 45 und einem LCD-Zeilentreiber 46. Zur Energieversorgung dieser Schaltung dient eine Stromversorgung 47, die von einer Fotovoltaik-Einheit 48 gespeist wird. Diese Einheit 48 wandelt Licht, das etwa von einer Lichtquelle direkt über die Lichtenergieträgerebene eingestrahlt wird, in eine elektrische Spannung um, die von der Stromversorgung 47 stabilisiert und zu den elektronischen Einheiten 43 bis 46 weitergeleitet wird. Die Ansteuerung des Display-Prozessors 42 geschieht vom Prozessor-Netzwerk 1 her über die Lichtwellenleiter 27. Der Prozessor 42 steuert die pro Zeile ablaufenden Bildpunkte bezüglich Helligkeit und Farbe mittels der LED-Spaltensteuerung 43 und des Spaltentreibers 44. Die vertikale Ansteuerung der jeweiligen LCD-Bildzeile führt der Display-Prozessor 42 über die LCD-Zeilensteuerung 45 und den Zeilentreiber 46 durch. Dabei werden die betreffenden Steuersignale durch die jeweiligen Treiber auf den erforderlichen Leistungspegel angehoben. Mit diesem Display ist es möglich, seriell nacheinander ablaufende farbige Bilder auf einem Halbleiter-Flachbildschirm mit reduzierter Informationsrate und konstanter Bildauflösung in einfacher Form, wie beim Farbfernsehen darzustellen.

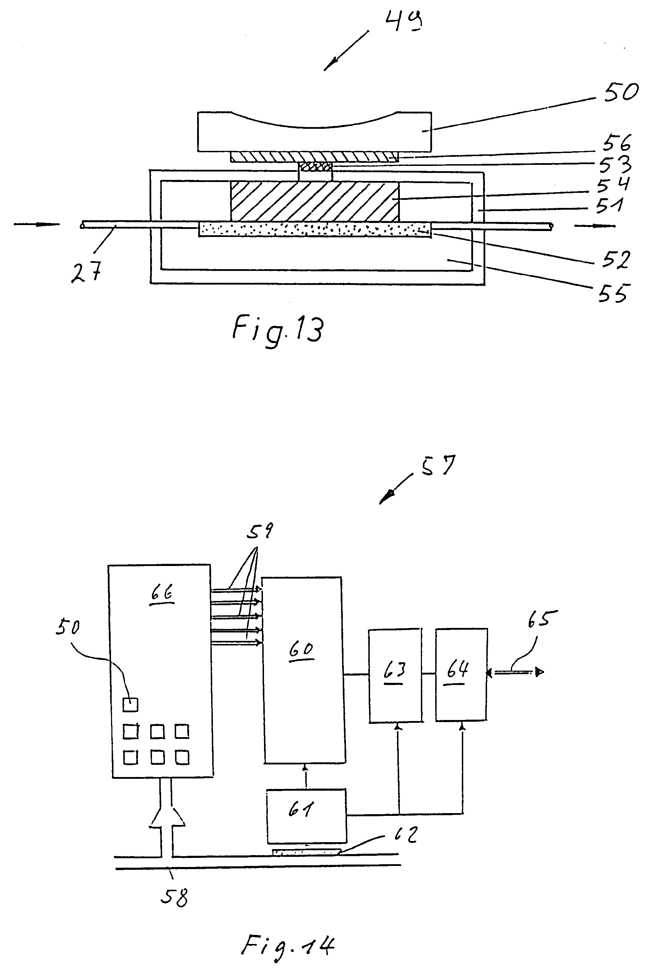

Fig. 13 zeigt einen Schnitt durch ein Tastatur-Element 49 mit einer Taste 50 und einer Kapsel 51 aus einem magnetisch abschirmenden Material, worin sich ein Trägermaterial mit einem Flüssigkristall 52 befindet. An den Kristall 52 ist seitlich je ein Lichtwellenleiter 27 angekoppelt. Oberhalb des Flüssigkristalls 52 befindet sich ein Hall-Generator 54, dessen elektrische Ausgänge mit den Anschlüssen des Kristalls 52 verbunden sind. An der Unterseite der Taste 50 ist eine Abschirmplatte 56 angeordnet, die einen Dauermagneten 53 trägt. Zwischen dem Dauermagneten 53 und dem Hallgenerator 54 wird ein Luftspalt durch eine Feder aufrecht erhalten. In nicht gedrückter Position der Taste 50 ist der Flüssigkristall 52 durchsichtig, so daß der von links in Pfeilrichtung eintretende Lichtstrom das Tastaturelement 49 ungehindert passieren kann. Wird nun die Taste 50 gedrückt, so nähert sich der Dauermagnet 50 dem Hallgenerator 54, so daß dieser eine Spannung an den Flüssigkristall 52 abgibt. Hierdurch wird der Flüssigkristall 52 dunkel gesteuert, so daß der besagte Lichtstrom unterbrochen wird. Damit sich eine deutliche Aus/Ein-Charakteristik ergibt, ist vorgesehen, daß ein schwellenspannungsabhängiges Hallgeneratorelement verwendet wird. Damit liegt ein rein optisch arbeitendes Tastaturelement vor, das weder durch magnetische noch durch elektromagnetische Einflüsse störbar ist.

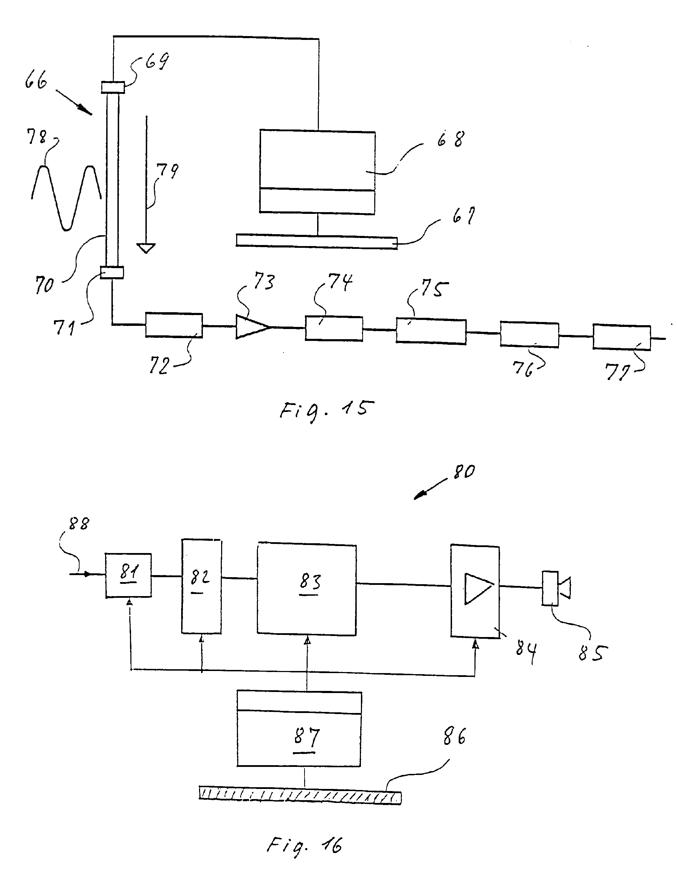

Fig. 14 zeigt eine Schaltung einer auf den Tastaturelementen 49 basierenden Eingabe-Tastatur 57 mit einem Eingabefeld 66, auf dem die einzelnen Tasten 50 angeordnet sind. Die Energieversorgung der Schaltung erfolgt über einen Lichtwellenleiter 58, an den sowohl das Eingabefeld 66 als auch eine Fotozellen-Schicht 62 angeschlossen sind. Das Eingabefeld 66 ist über Lichtwellenleiter 59 mit einem Tastatur-Dekoder und Bus-Coder 60 verbunden. Die vom Bus-Coder 60 gelieferten Signale durchlaufen einen Modulator 63 und einen Lichtsender 64, der mit einem Lichtwellenleiter 65 in Verbindung steht. Die von der Fotozellen-Schicht 62 gelieferte Spannung wird einer Energieversorgung 61 zugeführt, die die Einheiten 60, 63 und 64 mit einer geregelten Betriebsspannung versorgt. In Ruhestellung der Tasten 50 erscheint an allen Lichtwellenleitern 59 ein Dauerlichtsignal. Wird jedoch eine Taste 50 angeschlagen, so leitet der durch diese Taste 50 gesteuerte Lichtwellenleiter 59 einen Dunkelimpuls an den Tastatur-Dekoder 60 weiter, der daraufhin ein dem Zeichen der angeschlagenen Taste 50 entsprechendes elektrisches Digitalsignal erzeugt und an den Modulator 63 weiterleitet, der seinerseits mit dem Lichtsender 64 verbunden ist. Den aktiven Teil dieses Senders 64 bildet eine Laser-Diode, die ihr Ausgangssignal an das vorbeschriebene Prozessor-Netzwerk 1 sendet. Die gezeigten Einheiten sind innerhalb des Tastaturgehäuses angeordnet. Ein entsprechendes flexibles Anschlußkabel enthält sowohl den Lichtwellenleiter 65 für die zu übermittelnden Signale als auch den Lichtwellenleiter 58 für die Energieversorgung. Elektrische Zuleitungen existieren nicht. Damit ist auch diese Schaltung weder durch elektrische noch durch elektromagnetische Störungen beeinflußbar.

Fig. 15 zeigt ein Mikrofon 66 zur Eingabe von Sprachsignalen in ein Rechner-Netzwerk, wobei die Erzeugung und Übertragung der betreffenden Signale wieder weitgehend auf optischem Wege erfolgt. Eine Fotozellen-Schicht 67 steht über elektrische Leitungen mit einer Energieversorgung 68 in Verbindung, die ihrerseits mit einer Laserdiode 69 verbunden ist. Zwischen der Laserdiode 69 und einer Empfangsdiode 71 ist eine lichtleitende Membran 70 derart eingespannt, daß in deren Ruhelage Licht von konstanter Intensität auf die Diode 71 fällt. Die von der Diode 71 abgegebene Spannung wird einem Demodulator 72 zugeführt. Das vom Demodulator 72 gelieferte Signal gelangt über einen Verstärker 73 an den Eingang eines Frequenzanalysators 74 und durchläuft danach folgende Funktions-Einheiten; eine Codier-Einheit 75, einen Modulator 76 und eine Sendediode 77. Bei Auftreffen eines akustischen Signals 78 auf die Membran 70 gerät diese in entsprechende Schwingungen, wodurch der Lichtbrechungsindex der Membran 70 analog diesem Signal verändert wird. Hierdurch ändert sich die Lichtdurchlässigkeit der Membran 70 in Pfeilrichtung 79, so daß auch der durch die Membran 70 fließende Lichtstrom im gleichen Maße verändert wird. Damit erscheint am Ausgang der Diode 71 eine mit dem akustischen Signal modulierte elektrische Spannung. Diese tonfrequente Spannung wird in den nachgeschalteten Funktions-Einheiten zur Eingabe in die Rechnerschaltung 1 aufbereitet.

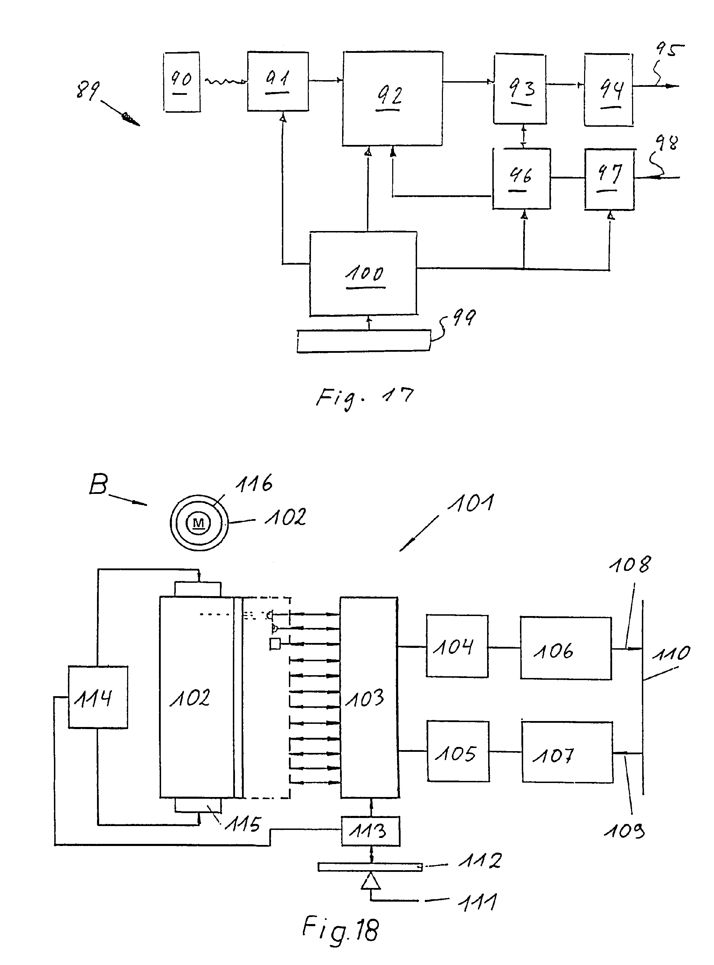

Fig. 16 zeigt ein Sprachausgabeteil 80, im wesentlichen bestehend aus einer optischen Empfangsdiode 81, einem Decoderteil 82, einem Sprachgenerator 83, einem Verstärker 84, und einem Lautsprecher 85. Auch hier ist eine optronische Energieversorgung, bestehend aus einer Fotozellen-Schicht 86 und einer Stromversorgungs-Einheit 87 vorgesehen. Die hier nicht gezeigte Rechnerschaltung 1 steht mit dem Sprachausgabeteil 80 über einen Lichtwellenleiter 88 in Verbindung. Die Funktions-Einheiten 81 bis 84 werden, wie vorbeschrieben, durch die Stromversorgungs-Einheit 87 mit einer geregelten Betriebs-Spannung versorgt. Gelangen nun über den Lichtwellenleiter 88 digital modulierte Lichtsignale zur Empfangsdiode 81, so wandelt diese das Lichtsignal in ein entsprechendes elektrisches Signal um, das dem Decoder 82 zugeleitet wird. Dieser läßt nur solche Signale passieren, die für den Sprachgenerator 83 bestimmt sind, der dann die wiederzugebenden Worte aus einzelnen Silben zusammensetzt. Hierzu verfügt der Sprachgenerator 83 über einen Silben-Speicher, in dem für jede vorkommende Silbe ein charakteristischer Befehlssatz enthalten ist, der die Erzeugung der betreffenden tonfrequenten Signale bestimmt. Die betreffenden Frequenzspektren werden von einem internen Digital-/Analogwandler geliefert. Die Sprachwiedergabe erfolgt dann über den Verstärker 84 mit dem angeschlossenen Lautsprecher 85.

Fig. 17 zeigt einen zur Aufnahme bewegter farbiger Bildinhalte dienenden Bildsensor 89 mit einem Objektiv 90, einem CCD-Matrix-Bildsensor 91, und einem Bildprozessor 92, der über einen Bildcoder 93 und einen Lichtsender 94 mit einem Lichtwellenleiter 95 verbunden ist. Ferner steht der Bildprozessor 92 über einen Bilddecoder 96 und einen Lichtempfänger 97 mit einem Lichtwellenleiter 97 in Verbindung. Alle genannten Funktions-Einheiten sind durch integrierte Halbleiterschaltkreise realisiert, zu deren Energieversorgung eine Fotozellen-Schicht 99 und eine Stromversorgungs-Einheit 100 vorgesehen sind. Der Datenaustausch mit der nicht gezeigten Rechner-Einheit 1 erfolgt über die Lichtwellenleiter 95 und 98. Zur Energieversorgung ist die Fotozellen-Schicht 99 über einen Energie-Lichtwellenleiter mit einer entsprechenden rechnerseitigen Lichtquelle verbunden.

Fig. 18 zeigt eine Massenspeicher-Anordnung 101 mit einer Schreib- Lese- und Lösch-Einheit 102, einer Schreib- Lese-Lösch-Steuerung 103 sowie einem Modulator-Coder 104 und einem Demodulator-Decoder 105, die jeweils über einen optischen Sender 106 bzw. Empfänger 107 über Lichtwellenleiter 108 und 109 mit einer optischen Datenleitung 110 verbunden sind. Die Versorgung mit Betriebsspannung erfolgt wieder über einen Leistungs-Lichtwellenleiter, der über eine Fotozellen-Schicht 112 eine Stromversorgungs-Einheit 113 speist. Diese Einheit versorgt sowohl die als integrierte Halbleiterschaltkreise ausgebildeten Funktions-Einheiten 103 bis 107 als auch einen Antriebsmotor 115, dem eine Motorsteuerung 114 vorgeschaltet ist. Das eigentliche Speicherelement bildet ein außen mit einer Datenträgerschicht versehener zylindrischer Speicher-Rotor 116. Die Beschichtung des Rotors 116 zeichnet sich dadurch aus, daß hierauf abzuspeichernde Daten optisch schreib- und lesbar sowie magnetisch löschbar sind. Der Zylinder 116 ist innerhalb der ebenfalls als Zylinder ausgebildeten Schreib- Lese- Lösch-Einheit 102 konzentrisch drehbar gelagert. Die Einzelheit B zeigt in einer seitlichen Projektion die konzentrische Anordnung der Zylinder 102 und 116. Der nicht rotierende Zylinder 102 trägt auf seiner Innenseite eine Vielzahl von Schreib-Lasern 117, Lesedioden 118 und Löschköpfen 119, die der Datenträger-Schicht unmittelbar gegenüber liegend angeordnet sind. Diese optronischen bzw. elektromagnetischen Elemente 117 bis 119 sind in mikrominiaturisierter Form flächendeckend auf einer biegsamen Folie angeordnet, die auf der Innenseite des Zylinders 102 befestigt ist. Durch die Drehbewegung des Speicherzylinders 116 und die in axialer Richtung dicht gedrängte Anordnung der Zugriffselemente (Schreiblaser 117, Lesedioden 118) wird auf der Mantelfläche des Zylinders 116 eine sehr große Anzahl von Datenspuren definiert. Da die Zugriffselemente 116,117 nicht nur in axialer sondern auch in Umfangsrichtung dicht gedrängt angeordnet sind, ist jeder Datenspur eine Vielzahl dieser Elemente zugeordnet. Alle Zugriffselemente 117, 118 sowie die gleichmäßig darunter verteilten Löschköpfe 119 sind über die Steuerung 103 mit den Knoten des Prozessor-Netzwerks 1 in Parallelschaltung verbunden. Diese Ausbildung eines Massenspeichers weist außer dem Zylinder 116 und dem Motor 115 keine beweglichen Teile auf. Beim Suchen nach einem bestimmten abgespeicherten Datensatz sind alle Lesedioden 118 gleichzeitig aktiviert. Hierdurch ergeben sich äuBerst kurze Zugriffszeiten. Von der Aktivierung eines Suchbefehls bis zum Auffinden des betreffenden Datensatzes vergehen nur Bruchteile einer Zylinder-Umdrehung.

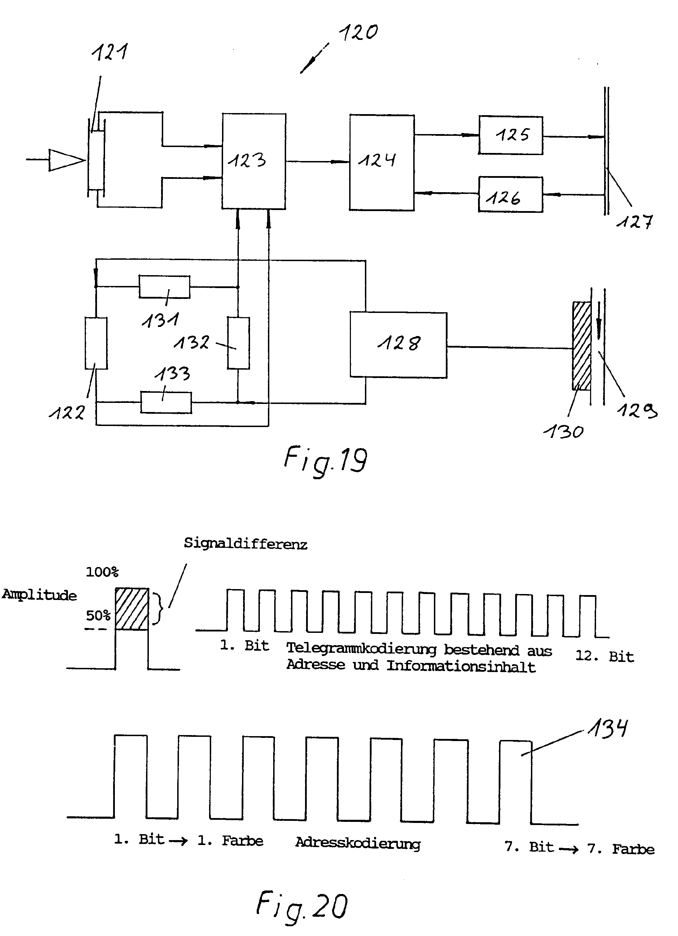

Fig. 19 zeigt eine Schaltung eines kombinierten Meßwertgebers 120 mit einem Piezo-Druck-Sensor 121 und einem Widerstands-Temperatur-Sensor 122. Beide Elemente sind über einen AD/Wandler 123, einen Coder/Decoder-Modulator 124 sowie eine Sende-Diode 125 und eine Empfangs-Diode 126 an einen mit dem Prozessor-Netzwerk in Verbindung stehenden Lichtwellenleiter 127 angeschlossen. Die als integrierte Halbleiterschaltkreise ausgebildeten Einheiten 123 bis 126 erhalten ihre Betriebsspannung von einer Stromversorgungs-Einheit 128, die von einem Energie-Lichtwellenleiter 129 über eine Fotozellen-Schicht 130 gespeist wird. Der Druck-Sensor 121 liefert eine dem festgestellten Druck proportionale elektrische Spannung an den A/D-Wandler 123, der daraufhin in bekannter Weise ein der anliegenden Spannung entsprechendes Digital-Signal erzeugt und über die weiteren Einheiten 124 bis 126 in den Lichtwellenleiter 127 einleitet. Der Temperatur-Sensor 122 bildet mit drei Widerständen 131,132,133 eine von der Stromversorgungs-Einheit 128 versorgte elektrische Brückenschaltung, deren Ausgangsleitung mit einem weiteren Eingang des Wandlers 123 verbunden ist. Die Wirkungsweise der hierbei angewendeten optronischen Datenübertragung ist nachfolgend näher erläutert.

Fig. 20 zeigt die Struktur der innerhalb des Prozessor-Netzwerks übertragenen Signale. Es werden grundsätzlich drei Arten von Informationen übertragen, nämlich die Prozessor-Funkions-Adressen, die Daten-Prioritäts-Information und die Dateninhalts-Information. Die Dateninhalts Information ist in die Daten-Adresse und den Dateninhalt selbst unterteilt. Mit diesen drei Informations-Arten wird der gesamte Datenverkehr innerhalb des Multiprozessor-Netzwerks abgewickelt.

Die Prozessor-Funktions-Adressen sind erforderlich, um bestimmte Aufgabengebiete geordnet in selbstoganisierter Form im neuronalen Netzwerk parallel bearbeiten zu können. Hierzu sind bestimmte sogenannte Mainprozessor-Bereiche definiert, die jeweils speziellen Aufgaben-Bereichen zugeordnet sind. Ein derartiges Aufgabengebiet ist beispielsweise die Verarbeitung mittels der Tastatur eingegebener Daten. So werden beispielsweise bei jeder Dateneingabe über die Tastatur sechs bestimmte Prozessoren mit ihrer Prozessor-Funktions-Adresse in Form eines festen Farbmultiplex-Codes als primär zugeordnete Prozessoren angesprochen. Diese Prozessoren prüfen hierbei in einer Auswahl fünf aus sechs, ob die nachfolgenden Daten korrekt übertragen werden. Weicht ein Prozessor mit seinem Prüf-Ergebnis vom Ergebnis der übrigen fünf ab, wird er als fehlerhaft abgeschaltet. Die verbleibenden Prozessoren prüfen sich nach dem gleichen Schema weiter und bestimmen einen benachbarten Standard-Prozessor zum Mainprozessor, der jetzt die Aufgaben des abgeschalteten Prozessors übernimmt.

Die Daten-Prioritäts-Information stellt einen weiteren wichtigen Übertragungsparameter insofern dar, als sie den Wichtigkeitsgrad, also die Priorität einer Information angibt. Es wird zunächst zwischen Daten von hoher und Daten von niederer Priorität unterschieden. Daten hoher Priorität werden direkt mit 50% der Farbträger-Amplitude ohne Basisträgeranteil gesendet. Daten von niederer Priorität werden auf 50% konstanter Farbträger-Amplitude aufmoduliert. Durch diese Maßnahme wird erreicht, daß die weit durchmodulierten Signale 134, also die Signale mit hoher Priorität, seitens der Decoder-Schaltungen des neuronalen Netzwerkes eine Vorrangbehandlung erfahren.

Die Dateninhalts-Information besteht aus zwei Teilen, nämlich einer Spezifischen Daten-Adresse sowie den eigentlichen zu übertragenden Daten. Dabei bildet jeder Teil ein digitales Datentelegramm von bestimmter Bitlänge.

Die vorgenannten drei Datentypen stellen die Grundlage der gesamten sich selbst organisierenden Daten-Übertragung innerhalb und außerhalb des neuronalen Netzwerks dar, dessen Wirkungsweise wie folgt erläutert wird. Für diesen Rechner existiert kein übergeordnetes Gesamt-Ablauf-Programm sondern die Datenverarbeitung und das Datenmanagement vollziehen sich nach vom Rechner selbst organisierten Verfahrensmustern. Jeder einzelne Prozessor besitzt sein eigenes Betriebssystem, das ihn in die Lage versetzt, die interne Programmablauf-Organisation durchzuführen und die externe Kommunikation mit den anderen Prozessoren zu organisieren. Das jeweilige prozessoreigene Betriebs-System ist in einem entsprechenden EEPROM abgelegt.

Um Datenkollissionen auf dem optischen Datenbus-Netzwerk zu vermeiden, werden nach jedem Informationszyklus, bestehend aus den Durchgaben der Prozessor-Funktions-Adresse, der Prioritäts-Information, und der Dateninhalts-lnformation alle Prozessoren wieder auf Empfang geschaltet. Hat ein Mainprozessor-Bereich Informationen mit Datenpriorität 1, so sendet er zunächst seine Prozessor-Funktions-Adresse in das Busnetzwerk und startet diese mit einem Einzelfarbträgersignal, das sofort als Sende-Sperrsignal für alle anderen Mainprozessoren gilt. Damit alle im Prioritätslevel 1 arbeitenden Prozessoren den Zugriff zum Datenbus erhalten, wird dieses sogenannte Schlüssel-Signal allen Mainprozessoren zyklisch zugeteilt. Nach einem kompletten Durchgang wird der Bus für den Datenverkehr der Prioritätsebene 2 geräumt. Diese arbeitet nach dem gleichen Verfahren, kann aber nach Abschluß ihres Durchgangs bei Vorliegen von Prioritätsdaten mit Level 1 wieder auf eine freie Prioritätslücke warten. Um nicht endlos beim Aufkommen vieler Daten vom Prioritätslevel 1 warten zu müssen, wird jedoch nach dreimaligem Durchgang für Level 1 ein freier Durchgang für Level 2 festgelegt. Die verschiedenen Dateninhalts-Informationen werden hierbei im Parallelverfahren über alle vorhandenen Farbträger übertragen. Somit ist eine maximale Durchsatzrate über das Busnetz gewährleiste.

Werden nunmehr komplexere Aufgaben, wie die der Mustererkennung, beispielsweise der Sprachanalyse, durchgeführt, so wird zunächst der für diese Aufgabe wie vorbeschrieben festgesetzte Bereich von Mainprozessoren angesprochen. Diese schalten nun so lange frei verfügbare Standard-Prozessoren in die Aufgabenstellung ein, bis deren Anzahl für eine sinnvolle Echtzeitbearbeitung im Parallelbetrieb ausreicht. Hierbei werden beispielsweise vorgegebene Bilder oder Muster parallel segmentiert und zunächst in die freien RAM's der Main- und Standard-Prozessoren übernommen, die dann ihrerseits ihnen zugeordnete Segmentsektoren und Spuren auf dem opto-magnetischen Massenspeicher anhand des vorbeschriebenen Kommunikations-Verfahren ansprechen. Hier werden dann die verarbeiteten Musterfolgen dauerhaft abgespeichert. Soll der Rechner sich innerhalb eines Lernvorganges an eine bestimmte Bildmusterabfolge durch Vergleich mit einer vorgegebenen Musterabfolge erinnern können, so vergleicht er pro Prozessor das im Massenspeicher befindliche Mustersegment mit dem im RAM befindlichen Segment. Abweichungen können somit als fehlerhaft erkannt und eliminiert werden.

Eine nicht gezeigte Ausgestaltung der Erfindung besteht darin, daß der Prozessor-Chip 11 von quadratischer oder rechteckiger Form ist.

Eine weitere nicht gezeigte Ausgestaltung der Erfindung besteht darin, daß der Speicherzylinder 116 außen und innen mit einer Datenträgerschicht versehen ist.

## Patentansprüche

1. Digitalrechner mit einer Multiprozessoranordnung, bei der jeder Prozessor als hochintegrierter Rechnerchip auf Halbleiterbasis ausgebildet ist, wobei die Prozessoren mittels Lichtwellenleiter zur Übertragung von Signalen verbunden sind und an den Digitalrechner periphere Geräte wie Tastaturen, Datenspeicher, Bildschirme, Bildsensoren, Sprachanalyse-Einheiten, Sprachsynthese-Einheiten, Meßgeber u. dgl. anschließbar sind, dadurch gekennzeichnet, daß die Lichtwellenleiter zu einem Lichtwellenleiter-Netzwerk verbunden sind, wobei jedem Knoten (26) des Lichtwellenleiter-Netzwerks mindestens ein Prozessorchip (11) zugeordnet ist, der an den Knoten (26) über einen optischen Sender (23) und einen optischen Empfänger (24) so angekoppelt ist, daß über den jeweiligen optischen Knoten (26) ein Informationsaustausch zwischen dem dem Knoten (26) zugeordneten Prozessorchip (11) und dem Lichtwellenleiter-Netzwerk erfolgt, daß jeder Prozessorchip (11) allseitig elektromagnetisch abgeschirmt ist und daß jeder Prozessorchip (11) die für den Betrieb erforderliche Energie über außerhalb der metallischen Abschirmung angeordnete Fotozellen als Lichtenergie über eine Lichtleiterschicht so zuführbar ist, daß bei Energieaufnahme und Kommunikation keine direkte elektrische Verbindung zwischen den Energiequellen und den Prozessorchips (11) einerseits und dem Lichtwellenleiter-Netzwerk und den Prozessorchips (11) andererseits besteht.

2. Digitalrechner nach Anspruch 1, mit einem jedem Prozessorchip zugeordneten photovoltaischen Umwandler zur Umwandlung von einfallendem Licht in eine zur Stromversorgung des Prozessorchips dienende elektrische Spannung, dadurch gekennzeichnet, daß der Prozessorchip (11) eine Lichtleiterschicht (13) aus einem optisch durchsichtigen Material und eine Fotozellen-Schicht (14) aufweist.

3. Digitalrechner nach den Ansprüchen 1 und 2, dadurch gekennzeichnet, daß der optische Knoten (26) eine Vielzahl von Empfangsdioden (36a, 36b, 36c...) und Sendedioden (36₁, 36₂, 36₃,...) aufweist, die paarweise auf der gleichen Farbfrequenz arbeiten.

4. Digitalrechner nach einem der Ansprüche 1 bis 3, bei dem jeder Prozessorchip (11) eine sechseckige Umrißform aufweist, dadurch gekennzeichnet, daß eine Vielzahl von Prozessorchips (11) formschlüssig zu einer ProzessorEbene zusammengefügt sind, wobei die Chipgrenzen durch die metallische Randschicht (25) gebildet werden.

5. Digitalrechner nach einem der Ansprüche 1 bis 4, dadurch gekennzeichnet, daß die Maschen des Lichtleiter-Netzwerks die Form gleichseitiger Dreiecke aufweisen.

6. Digitalrechner nach einem der Ansprüche 1 bis 5, dadurch gekennzeichnet, daß eine Vielzahl von Prozessor-Ebenen zu einem Block vereinigt ist, wobei an geeigneten Stellen optische Datenwege zwischen den einzelnen Prozessor-Ebenen bestehen.

7. Digitalrechner nach einem der Ansprüche 1 bis 6, dadurch gekennzeichnet, daß für die Energieversorgung der peripheren Geräte jeweils eine Fotozellen-Schicht (14, 99, 112, 129) vorgesehen ist, die mit einem Energie-Lichtleiter (129) in Verbindung steht.

## Claims

1. A digital processor with a multi-processing system, in which each processor is a highly integrated semi-conductor chip, whereby the processors are connected by means of light wave conductors for converting signals and may be connected up to the digital processors of peripherals such as keyboards, data memories, visual display units, video sensors, language analysis units, language synthesising units, measuring devices etc., characterised in that the light wave conductor is connected to a light wave conductor network, in which at least one processor chip (11) is assigned to each node (26) of the light wave conductor network, which is coupled with the node (26) by means of an optical transmitter (23) and an optical receiver (24) so that data is exchanged between the processor chip (11) assigned to each node (26) and the light wave conductor network, in that each processor chip (11) is electromagnetically screened on all sides and that each processor chip (11) can convey the energy required for operation as light energy through a light conducting layer via photo cells outside the metallic screen in such a way that no direct electrical connection is made between the power sources and the processor chips (11) on the one hand and between the light wave conductor network and the processor chips (11) on the other for energy input or communications.

2. A digital processor in accordance with claim 1, in which a photovoltaic convertor is assigned to each processor chip to convert light falling on it to an electric current that can be used to power the processor chips, characterised in that the processor chip (11) has a light conductor layer (13) made from an optically transparent material and a photo cell layer (14).

3. A digital processor in accordance with claims 1 and 2, characterised in that the optical node (26) has a plurality of receiving diodes (36a, 36b, 36c...) and emitting diodes (36₁, 36₂, 36₃ ...), which operate in pairs on the same colour frequency.

4. A digital processor in accordance with one of claims 1 to 3, in which each processor chip (11) has a hexagonal outline form, characterised in that a plurality of processor chips (11) are tessellated to form a processor level, in which the chip borders are formed by a metal peripheral layer (25).

5. A digital processor in accordance with one of claims 1 to 4, characterised in that the interstices of the light conductor network are in the form of equilateral triangles.

6. A digital processor in accordance with one of claims 1 to 5, characterised in that a plurality of processors levels are united to form one block, in which optical data channels are formed at suitable points between the individual processor levels.

7. A digital processor in accordance with one of claims 1 to 6, characterised in that a photo cell layer (14, 99, 112, 129) is provided to supply energy to each of the pieces of peripheral equipment, which is connected to a energy-light conductor (129).

## Revendications

1. Ordinateur digital muni d'une implantation de multiprocesseurs pour laquelle chaque processeur est conçu en tant que puce à semi-conducteur complètement intégrée, les processeurs étant connectés au moyen de guides d'ondes lumineuses pour la transmission de signaux et des appareils périphériques comme des claviers, des mémoires de données, des écrans vidéo, des détecteurs d'image, des unités d'analyse de la parole, des unités de synthèse de la parole, des capteurs de mesure et des appareils similaires pouvant être connectés à l'ordinateur digital, caractérisé en ce que les guides d'ondes lumineuses sont connectés à un réseau de guides d'ondes lumineuses, au moins une puce de processeur (11) étant affectée à chaque noeud (26) du réseau de guides d'ondes lumineuses, puce qui est couplée au noeud (26) par l'intermédiaire d'un émetteur optique (23) et d'un récepteur optique (24) de façon à ce qu'un échange d'informations s'effectue par l'intermédiaire de chaque noeud optique (26) entre la puce de processeur (11) affectée à ce noeud (26) et le réseau de guides d'ondes lumineuses, en ce que chaque puce de processeur (11) est protégée sur toutes les faces de façon électromagnétique et en ce que l'énergie indispensable pour le fonctionnement peut être amenée à chaque puce de processeur (11) par l'intermédiaire de cellules photo-électriques disposées en dehors de l'écrannage en tant qu'énergie optique par l'intermédiaire d'une couche de guides de lumière, de façon à ce que, lors de l'absorption d'énergie et de la transmission, il n'existe aucune connexion électrique directe entre les sources d'énergie et les puces (11), d'une part, et le réseau de guides d'ondes lumineuses et les puces de processeur (11), de l'autre.

2. Ordinateur digital selon la revendication 1, muni d'un convertisseur photovoltaïque affecté à chaque puce de processeur et destiné à convertir une lumière incidente en une tension électrique servant d'alimentation en énergie électrique de la puce du convertisseur, caractérisé en ce que la puce du processeur (11) présente une couche de guides de lumière (13) provenant d'une matière optiquement transparente et une couche de cellules photo-électriques (14).

3. Ordinateur digital selon les revendications 1 et 2, caractérisé en ce que le noeud optique (26) présente une multitude de diodes de réception (36a, 36b, 36c...) et de diodes d'émission (36₁, 36₂ , 36₃,...) qui fonctionnent de façon jumelée sur la même fréquence de couleur.

4. Ordinateur digital selon l'une des revendications 1 à 3, pour lequel chaque puce de processeur (11) présente un profil hexagonal, caractérisé en ce qu'une multitude de puces de processeur (11) est assemblée par crabot pour former un plan de processeurs, les limites des puces étant formées par la couche marginale métallique (25).

5. Ordinateur digital selon l'une des revendications 1 à 4, caractérisé en ce que les mailles du réseau de guides de lumière ont la forme de triangles équilatéraux.

6. Ordinateur digital selon l'une des revendications 1 à 5, caractérisé en ce qu'une multitude de plans de processeurs est réunie en un bloc, des circuits optiques de l'information existant entre les différents plans de processeurs, à des emplacements appropriés.

7. Ordinateur digital selon l'une des revendications 1 à 6, caractérisé en ce qu'une couche de cellules photoélectriques (14, 99, 112, 129) qui est connectée à un guide de lumière et d'énergie (129) est prévue à chaque fois pour l'alimentation en énergie des appareils périphériques.
